(19) **Europäisches Patentamt / European Patent Office / Office européen des brevets**

(11) **EP 4 115 525 B1**

(12) **EUROPÄISCHE PATENTSCHRIFT**

(45) Veröffentlichungstag und Bekanntmachung des Hinweises auf die Patenterteilung:
**13.08.2025 Patentblatt 2025/33**

(21) Anmeldenummer: **21710432.2**

(22) Anmeldetag: **04.03.2021**

(51) Internationale Patentklassifikation (IPC):
*H03K 17/082* (2006.01)

(52) Gemeinsame Patentklassifikation (CPC):
**H03K 17/0822;** Y02B 70/10

(86) Internationale Anmeldenummer:
**PCT/EP2021/055488**

(87) Internationale Veröffentlichungsnummer:
**WO 2021/176003 (10.09.2021 Gazette 2021/36)**

(54) **TREIBERSCHALTUNG FÜR EIN NIEDERINDUKTIVES LEISTUNGSMODUL SOWIE EIN NIEDERINDUKTIVES LEISTUNGSMODUL MIT ERHÖHTER KURZSCHLUSSFESTIGKEIT**

DRIVER CIRCUIT FOR A LOW INDUCTIVE POWER MODULE AND A LOW INDUCTIVE POWER MODULE WITH ENHANCED SHORT CIRCUIT WITHSTAND CAPABILITY

CIRCUIT D'ATTAQUE POUR UN MODULE DE PUISSANCE INDUCTIVE FAIBLE ET MODULE DE PUISSANCE INDUCTIVE FAIBLE AYANT UNE CAPACITÉ DE TENUE DE COURT-CIRCUIT AMÉLIORÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.03.2020 DE 102020202842**

(43) Veröffentlichungstag der Anmeldung:
**11.01.2023 Patentblatt 2023/02**

(73) Patentinhaber: **Robert Bosch GmbH
70442 Stuttgart (DE)**

(72) Erfinder:
• **STRACHE, Sebastian
72827 Wannweil (DE)**
• **OBERDIECK, Karl
72654 Neckartenzlingen (DE)**
• **MAIER, Christian
72770 Reutlingen (DE)**

(56) Entgegenhaltungen:
**EP-A1- 1 988 632       EP-A1- 2 999 118
EP-A1- 3 035 532       JP-A- 2007 174 134
JP-A- 2010 124 627**

**Beschreibung**

Die vorliegende Erfindung betrifft eine Treiberschaltung für ein niederinduktives Leistungsmodul, welche einen Anschluss und einen Ausgang umfasst, wobei der Anschluss mit dem Source-Kontakt eines Leistungstransistors und der Ausgang mit dem Gate-Kontakt des Leistungstransistors verbindbar ist. Die Treiberschaltung ist dazu ausgelegt, in einem ersten Betriebsmodus eine erste Gate-Source-Spannung für den Gate-Kontakt des Leistungstransistors zu erzeugen und an dem Ausgang der Treiberschaltung zur Verfügung zu stellen.

Stand der Technik

Niederinduktive Leistungsmodule, insbesondere Leistungsmodule die Halbleiter mit großer Bandlücke nutzen wie beispielsweise Siliziumcarbid MOSFETs (SiC MOSFETs) bieten - verglichen beispielsweise mit anderen Schaltmitteln - signifikante Vorteile im Bereich der Schaltverluste, was unter anderem zu größeren Reichweiten von Elektrofahrzeugen beiträgt. Um überlegene Schaltleistungen mit großen schaltbaren Spannungen (du/dt > 10V/ns) und großen schaltbaren Strömen (di/dt > 1A/ns) zu ermöglichen, werden für besagte Leistungsmodule Module mit kleiner Induktivität (L < 15nH) benötigt.

Zur Erreichung der oben erwähnten überlegenen Schaltleistung werden die hier in Rede stehenden Leistungsmodule meist auf dünnen Chips zur Verfügung gestellt, welche - verglichen mit anderen, auf dickeren Chips bereitgestellten Leistungsmodulen - eine geringere thermische Kapazität aufweisen, was die Zeitspanne verkleinert, während derer die Leistungsmodule einem Kurzschluss widerstehen beziehungsweise standhalten können. Hierbei spielen insbesondere zwei verschiedene, sogenannte Kurzschlusstypen beziehungsweise Kurzschlussbedingungen eine hervorzuhebende Rolle.

Beim sogenannten Kurzschlusstyp 1 tritt ein Kurzschluss direkt bei beziehungsweise während des Einschaltvorgangs des Leistungsmoduls - insbesondere eines Leistungstransistors - auf, während beim sogenannten Kurzschlusstyp 2 ein Kurzschluss nach dem Einschaltvorgang des Leistungsmoduls beziehungsweise des Leistungstransistors auftritt. So ist die oben beschriebene, erhöhte Schaltleistung besonders mit Blick auf den Kurzschlusstyp 1 kritisch, da zum Beispiel ein Leistungstransistor wie ein Leistungs-MOSFET im Kurzschlusstyp 1- Kurzschlussfall mit einer hohen Gate-Source-Spannung, $U_{GS}$, eingeschaltet und mit einer sehr hohen Drain-Source-Spannung, $U_{DS}$, betrieben wird. Dies kann beispielsweise passieren, wenn der Komplementärpartner des kurzgeschlossenen Leistungs-MOSFETs (zum Beispiel innerhalb einer Inverter-Schaltung) beschädigt ist. In einem solchen Fall muss eine mit dem Leistungsmodul beziehungsweise dem Leistungstransistor verbundene Kurzschluss-Überwachungsschaltung, welche im Falle einer Überwachungsschaltung der Spannung über einem Leistungstransistor im Englischen oft auch als "Desaturation Detection Circuit" (DeSat) bezeichnet wird, das Vorliegen des Kurzschlussfalls erkennen und das Leistungsmodul beziehungsweise den Leistungstransistor abschalten. Die vorbezeichnete Überwachungsschaltung reagiert auf die Halbleiterspannung und ist deshalb im Schaltmoment unwirksam geschaltet, der sogenannten Ausblendzeit (im Englischen oft auch als "blanking time" bezeichnet). Zusätzlich zu dieser Ausblendzeit gibt es eine Reaktionszeit, in der die kurzgeschlossenen Leistungshalbleiter abgeschaltet werden. Diese Ausblend- und Reaktionszeit darf nicht denjenigen Maximalzeitraum überschreiten, innerhalb dessen das Leistungsmodul beziehungsweise der Leistungstransistor noch in der Lage ist, einem Kurzschluss zu widerstehen/standzuhalten, bevor es/er ausfällt.

Auf Grund des bei der oben beschriebenen überlegenen Schaltleistung gegebenen, nur kurzen Stromanstiegszeitraums, also auf Grund des schnellen Stromanstiegs, kommt es während der oben beschriebenen Ausblend- und Reaktionszeit zu einer signifikanten Stromüberschreitung, bei welcher Ströme fließen, die zehnmal so groß sind wie der Nominalstrom. Diese Stromüberschreitung führt zu einer signifikanten Aufheizung des Leistungsmoduls beziehungsweise des Leistungstransistors, was eine zusätzliche Degradation des Leistungsmoduls/Leistungstransistors bewirkt, was den oben beschriebenen Maximalzeitraum, während welchem der Leistungstransistor noch in der Lage ist, einem Kurzschluss zu widerstehen, verkürzt.

Beim sogenannten Kurzschlusstyp 2 tritt ein Kurzschluss auf, während sich das Leistungsmodul beziehungsweise der Leistungstransistor bereits im (vollständig) eingeschalteten Zustand befindet. Dies kann beispielsweise passieren, wenn der Komplementärpartner eines kurzgeschlossenen Leistungs-MOSFETs (zum Beispiel innerhalb einer Inverter-Schaltung) im eingeschalteten Zustand beschädigt wird. Nach einem Fehler des Leistungsmoduls/Leistungstransistors, also beispielsweise nach einem Ausfall des komplementären Schalttransistors, erhöht sich zunächst der durch den Leistungstransistor fließende Strom di/dt und im Anschluss daran die in diesem vorherrschende Spannung.

Auf Grund eines Verschiebungsstroms, welcher sich während der Erhöhung der Transistor-Spannung du/dt einstellt, erhöht sich die Gate-Source-Spannung $U_{GS}$ des Leistungstransistors über den normalen Einschaltwert hinaus. Die Erhöhung der Gate-Source-Spannung $U_{GS}$ über den normalen Einschaltwert hinaus erhöht den Kurzschlussstrom noch weiter. Eine Kurzschluss-Überwachungsschaltung (siehe oben: "Desaturation Detection Circuit" (DeSat)) beziehungsweise eine Abschaltschaltung, welche die Stromveränderung di/dt über der Zeit mittels einer Hilfsinduktivität misst, triggert den Abschaltprozess des Leistungstransistors. Allerdings vermag die Kurzschluss-Überwachungsschaltung nicht die Belastung (insbesondere bei Spitzenströmen) des Leistungsmoduls/Leistungstransistors während derartiger Fehlerfälle zu reduzieren. Solche Belastungen, insbesondere Beanspruchungen innerhalb des Leistungsmoduls/Leistungstransistors, können zu einer Degradation der Parameter eben dieses Leistungsmoduls/-Leistungstransistors führen.

Verschiedene Verfahren beziehungsweise Schaltungsvarianten existieren im Stand der Technik, um den oben beschriebenen Widerstands-Maximalzeitraum - während dem das Leistungsmodul beziehungsweise der Leistungstransistor einem Kurzschluss zerstörungsfrei standzuhalten in der Lage ist - zu verlängern. Dabei führen beispielsweise konventionelle Verfahren wie das Gate-Source Feedback oder das Vorsehen eines höheren Gate-Widerstands zu einer Verringerung der Schaltleistung des Leistungsmoduls/Leistungstransistors und erhöhen daher die Schaltenergie. Weitere derartige Verfahren sind beispielsweise in der US 9490798 B1 oder in der US 10193544 B2 detailliert beschrieben.

EP 3 035 532 A1 offenbart eine Gate-Treiberschaltung zum Anlegen einer Spannung an ein Gate einer Halbleiter-Schaltvorrichtung umfassend: einen Gate-Treiber-Controller, der Spannungsbefehle zum Betreiben der Halbleiter-Schaltvorrichtung bereitstellt; mehrere primäre Gate-Widerstände, die zwischen den Gate-Treiber-Controller und die Halbleiter-Schaltvorrichtung geschaltet sind; einen oder mehrere sekundäre Gate-Widerstände, die parallel zu den primären Gate-Widerständen geschaltet sind; einen primären Transistor, der mit jedem der primären Gate-Widerstände in Reihe geschaltet ist; und einen sekundären Transistor, der mit jedem der sekundären Gate-Widerstände in Reihe geschaltet ist.

EP 2 999 118 A1 offenbart eine Halbleitervorrichtung, welche eine Gate-Spannung steuert, die an eine Gate-Elektrode eines Sperrschicht-Feldeffekttransistors mit einer Source-Elektrode, einer Drain-Elektrode und der Gate-Elektrode anzulegen ist, wobei der Transistor eine erste Schwellenspannung aufweist, bei der der Transistor eingeschaltet wird, und einen zweiten Schwellenwert, bei dem eine Leitfähigkeitsmodulation in dem Transistor auftritt, um die Gatespannung gleich oder höher als die zweite Schwellenspannung zu machen, wenn ein Vorwärtsstrom in einer Richtung von der Drainelektrode zur Sourceelektrode fließt, und um die zeitliche Veränderung der Gatespannung einen Punkt haben zu lassen, ab dem die Rate der zeitlichen Veränderung bei einer Spannung zwischen der zweiten Schwellenspannung und der ersten Schwellenspannung abzunehmen beginnt, wenn der Vorwärtsstrom abgeschaltet werden soll.

Offenbarung der Erfindung

Erfindungsgemäß wird eine Treiberschaltung für ein niederinduktives Leistungsmodul zu Verfügung gestellt, welche einen Anschluss und einen Ausgang umfasst. Der Anschluss ist mit dem Source-Kontakt eines Leistungstransistors und der Ausgang ist mit dem Gate-Kontakt des Leistungstransistors verbindbar. Die Treiberschaltung ist dazu ausgelegt, in einem ersten Betriebsmodus eine erste Gate-Source-Spannung für den Gate-Kontakt des Leistungstransistors zu erzeugen und an dem Ausgang der Treiberschaltung zur Verfügung zu stellen. Erfindungsgemäß ist die Treiberschaltung ferner dazu ausgelegt, in einem zweiten Betriebsmodus während wenigstens einer voreingestellten Mindestzeitspanne eine geringere zweite Gate-Source-Spannung für den Gate-Kontakt des Leistungstransistors zu erzeugen und an dem Ausgang der Treiberschaltung zur Verfügung zu stellen. Die voreingestellte Mindestzeitspanne entspricht derjenigen Zeitspanne, die von einer mit dem Leistungstransistor verbundenen Kurzschluss-Erkennungsschaltung benötigt wird, um einen Kurzschluss bei der Einschaltung des Leistungstransistors zu erkennen und eine Abschaltung des Leistungstransistors einzuleiten und/oder vorzunehmen.

Mit einer derartigen Treiberschaltung ist es vorteilhaft möglich, das Leistungsmodul beziehungsweise den Leistungstransistor bei gleichbleibendem Schaltverhalten, also bei gleichbleibender Schaltleistung beziehungsweise Schalteffizienz mit den bekannten geringen Leistungsverlusten, vor einer Beschädigung durch einen Kurzschluss - in beiden zuvor beschriebenen Kurzschluss-Fällen 1 und 2 - wirksam zu schützen. Dies geschieht, indem die Treiberschaltung den Betrieb des Leistungsmoduls/Leistungstransistors in zwei verschiedenen Betriebsmodi mit zwei verschiedenen Gate-Source-Spannungen erlaubt. Für einen Schutz gegen den Kurzschlusstypen 1 wird die Stromspitze im Leistungsmodul/dem Leistungstransistor (welche sich während des Kurzschlussfalls einstellt) durch eine Reduktion der Gate-Source-Spannung in einer Zeitspanne während der Kurzschluss-Detektionszeit (also während einiger Mikrosekunden) der Kurzschluss-Überwachungsschaltung bzw. Kurzschluss-Erkennungsschaltung (DeSat) im zweiten Betriebsmodus herabgesetzt. Auf Grund dieser Herabsetzung der Gate-Source-Spannung ist der Sättigungsstrom des Leistungsmoduls/Leistungstransistors im Ausgangskennlinienfeld (also der Strom $I_D = f(U_{DS})$, das heißt der Drain-Strom $I_D$ als Funktion der Drain-Source-Spannung) reduziert. Nach Ablauf der voreingestellten Mindestzeitspanne erhöht die Treiberschaltung im ersten Betriebsmodus die Gate-Source-Spannung von der zweiten auf die erste Gate-Source-Spannung und stellt diese am Ausgang der Treiberschaltung für den Gate-Kontakt eines mit dem Ausgang der Treiberschaltung verbundenen Leistungstransistors zur Verfügung. Nach Ablauf der voreingestellten Mindestzeitspanne wird also (wieder) die nominale Gate-Source-Spannung des Leistungstransistors innerhalb der Treiberschaltung erzeugt bzw. generiert und am Ausgang der Treiberschaltung zur Verfügung gestellt. Dies ermöglicht den bekannten, vorteilhaften Betrieb des Leistungstransistors mit geringen Leitungsverlusten, welcher sich insbesondere bei der Verwendung von SiC MOSFETs einstellt, bei gleichzeitig verbessertem Kurzschlussschutz. Die gesteigerte Leitungsverlustenergie während der Verringerung der Gate-Source-Spannung im zweiten Betriebsmodus kann folgendermaßen berechnet werden,

$$\Delta J_{cond} = (R_{DSon}, u_{GS1} - R_{DSon}, u_{GS2}) * I_D^2 * tu_{GS1}$$

$$\Delta J_{cond} = U_{DS} * I_D * tu_{GS1},$$

wobei $\Delta J_{cond}$ die Veränderung der Leitungsverlustenergie ist, $R_{DSon}, u_{GS1}$ der On-State Widerstand der Drain-Source-Strecke des Leistungstransistors bei der ersten Gate-Source-Spannung im ersten Betriebsmodus ist, $R_{DSon}, u_{GS2}$ der On-State Widerstand der Drain-Source-Strecke des Leistungstransistors bei der zweiten Gate-Source-Spannung im zweiten Betriebsmodus ist, $I_D$ der Drain-Strom des Leistungstransistors ist und $tu_{GS1}$ die voreingestellten Mindestzeitspanne ist. Zu beachten ist, dass die verringerte zweite Gate-Source-Spannung immer noch groß genug zu wählen ist, sodass eine sichere beziehungsweise normale Einschaltung des Leistungstransistors gewährleistet bleibt.

Bevorzugt entspricht die voreingestellte Mindestzeitspanne derjenigen Zeitspanne, die von einer mit dem Leistungstransistor verbundenen Kurzschluss-Erkennungsschaltung benötigt wird, um einen Kurzschluss bei der Einschaltung des Leistungstransistors zu erkennen und eine Abschaltung des Leistungstransistors einzuleiten und/oder vorzunehmen. In einer derartigen Ausführung ist das Leistungsmodul beziehungsweise der Leistungstransistor in einem mit der erfindungsgemäßen Treiberschaltung verbundenen Zustand besonders gut vor einer kurzschlussbedingten Beschädigung beziehungsweise Degradation geschützt.

Gemäß einer bevorzugten Ausführung wird der zweite Betriebsmodus durch die Erkennung einer Einschaltung eines mit der Treiberschaltung verbundenen Leistungstransistors initiiert.

Vorzugsweise umfasst die Treiberschaltung zwei verschiedene Spannungsquellen, mittels welcher die erste und die zweite Gate-Source-Spannung erzeugbar und am Ausgang der Treiberschaltung zur Verfügung stellbar sind. Auf diese Weise können die zwei verschiedenen Gate-Source-Spannungen besonders sicher und im schnellen Wechsel zur Verfügung gestellt werden.

In einer bevorzugten Ausführungsform der Erfindung haben die zwei verschiedenen Spannungsquellen jeweils einen mit dem Anschluss der Treiberschaltung verbundenen Eingang sowie jeweils einen Spannungsausgang, wobei der Spannungsausgang der ersten Spannungsquelle über eine Reihenschaltung aus einer ersten Diode und einem ersten Widerstand mit dem Ausgang der Treiberschaltung verbunden ist, während der Spannungsausgang der zweiten Spannungsquelle über eine Parallelschaltung zweier Pfade mit dem Ausgang der Treiberschaltung verbunden ist, wobei in jedem der Pfade eine Diode und/oder ein Widerstand vorgesehen ist. Über die zwei verschiedenen Spannungsausgänge, die ihrerseits jeweils mit dem Ausgang der Treiberschaltung elektrisch leitfähig verbunden sind, lassen sich die Gate-Source-Spannungen nicht nur besonders gut und genau einstellen, sondern auch kontrollieren.

Bevorzugt ist in einigen Ausführungsformen der Gate-Widerstand - verglichen mit den Gate-Widerständen bei herkömmlichen Treiberschaltungen beziehungsweise verglichen mit dem Gate-Widerstand in einem Spannungspfad, welcher für die Bereitstellung der zweiten Gate-Source-Spannung im zweiten Betriebsmodus vorgesehen ist - reduziert beziehungsweise reduziert gewählt.

Insbesondere bei derartigen Ausführungsformen kann die gleiche Schaltleistung beziehungsweise Schalteffizienz beibehalten werden, besonders verglichen zu einer Treiberschaltung, mittels welcher lediglich eine Gate-Source-Spannung zur Verfügung stellbar ist. Auch garantiert ein solcher, verringerter Gate-Widerstand, dass es bei Anliegen der reduzierten zweiten Gate-Source-Spannung nicht zu einer Einschaltverzögerung des Leistungstransistors kommt.

Bevorzugt umfasst die Treiberschaltung ferner eine Ansteuerschaltung, welche die Spannungsquellen entsprechend eines vorbestimmten Algorithmus betreibt. Bevorzugt umfasst die Ansteuerschaltung einen Controller, insbesondere einen Microcontroller, einen Computer oder einen Microcomputer. In anderen erfindungsgemäßen Ausführungsvarianten kann die erfindungsgemäße Treiberschaltung auch lediglich Steuermittel und/oder einen Steueranschluss (und keine eigene Ansteuerschaltung) umfassen, welche dazu ausgebildet sind, von einer externen, außerhalb der Treiberschaltung vorgesehenen Ansteuerschaltung gesteuert zu werden. Solche Steuermittel können beispielsweise Schaltmittel umfassen, mittels welcher die Spannungsquellen jeweils in einen aktiven oder inaktiven Zustand schaltbar sind. Bevorzugt umfasst die Ansteuerschaltung eine Zeitnehmer-Schaltung (im englischen oft auch als Timer bezeichnet). In einer derartigen Ausführung kann die Steuerung der Spannungsquellen vorteilhafterweise direkt in und von der Treiberschaltung selbst vorgenommen werden. Dies ermöglicht den autonomen Einsatz der Treiberschaltung gemeinsam mit dem Leistungsmodul/Leistungstransistor.

Bevorzugt umfasst die Ansteuerschaltung einen RC-Schaltkreis beziehungsweise einen RC-Schwingkreis.

Vorzugsweise ist zwischen dem Ausgang und dem Anschluss der Treiberschaltung mindestens eine Spannungsquelle vorgesehen, mittels welcher der Ausgang der Treiberschaltung mit einer Spannung beaufschlagbar ist, wobei mindestens eine Induktivität mittels eines Schaltmittels dem elektrischen Pfad zwischen der mindestens einen Spannungsquelle und dem Anschluss reversibel hinzuschaltbar ist. In einer derartigen Ausführungsform ist die erfindungsgemäße Treiberschaltung besonders gut gegen Kurzschlüsse des Kurzschlusstyps 2 geschützt. Die reversibel hinzuschaltbare Induktivität fungiert hier als optionales Source Feedback für einen mit der Treiberschaltung verbundenen Leistungstransistor, welches Kurzschluss-Stromspitzen innerhalb des Leistungsmoduls/Leistungstransistors bei gleichbleibender Schaltleistung reduziert. Bevorzugt bedeutet die Formulierung reversibel hinzuschaltbar, dass die Induktivität - in einem mit dem Leistungsmodul/Leistungstransistor verbundenen Zustand der Treiberschaltung - in einer ersten Stellung des Schaltmittels einer Rückkopplungsschleife, welche den Source-Anschluss des Leistungstransistors über eine die Gate-Spannung bereitstellende Spannungsquelle und einen Gate-Widerstand mit dem Gate-Anschluss des Leistungstransistors verbindet, hinzugeschaltet ist und in einer zweiten Stellung des Schaltmittels aus dieser Rückkopplungsschleife herausgekoppelt ist. In dieser Ausführung ist die erfindungsgemäße Treiberschaltung also mit einer auswählbaren Source-Verbindung ausgestattet. Bevorzugt ist die Treiberschaltung dazu ausgebildet, die Induktivität während des Einschaltvorgangs des Leistungsmoduls beziehungsweise des Leistungstransistors dem elektrischen Pfad zwischen der mindestens einen Spannungsquelle und dem Anschluss nicht hinzuzuschalten. Mit anderen Worten ausgedrückt ist die Treiberschaltung bevorzugt dazu ausgebildet, die Induktivität während des Einschaltvorgangs des Leistungsmoduls beziehungsweise des Leistungstransistors aus dem elektrischen Pfad zwischen der mindestens einen Spannungsquelle und dem Anschluss der Treiberschaltung herauszukoppeln. Des Weiteren ist die Treiberschaltung bevorzugt dazu ausgebildet, die Induktivität nach Abschluss des Einschaltvorgangs dem elektrischen Pfad zwischen der mindestens einen Spannungsquelle und dem Anschluss der Treiberschaltung hinzuzuschalten, also in diesen einzukoppeln. Bevorzugt wird dieses Hinzu- oder Herausschalten beziehungsweise das Ein- oder Auskoppeln der Induktivität durch die oben beschriebene oder durch eine weitere Ansteuerschaltung beziehungsweise über die oben beschriebenen oder durch weitere Steuermittel und/oder über einen Steueranschluss durchgeführt. Besonders bevorzugt kann diese, eine reversibel hinzuschaltbare Induktivität umfassende Ausführungsform mit den zuvor beschriebenen Ausführungsformen kombiniert werden.

Bevorzugt umfasst die Treiberschaltung ferner eine weitere Spannungsquelle, welche mit der Induktivität in Reihe geschaltet ist und mittels des Schaltmittels gemeinsam mit der Induktivität dem elektrischen Pfad zwischen der mindestens einen Spannungsquelle und dem Anschluss reversibel hinzuschaltbar ist. In dieser Ausführungsvariante ist die Treiberschaltung besonders einfach und kostengünstig gegen Kurzschlüsse sowohl des ersten Kurzschlusstyps 1 als auch des zweiten Kurzschlusstyps 2 geschützt ohne die Schaltenergien zu erhöhen.

Ferner bevorzugt weist mindestens eine der Spannungsquellen der Treiberschaltung einen linearen Regler, einen RC Spannungsteiler, mindestens einen Bipolar-Transistor und/oder eine Bootstrap-Schaltung auf und/oder ist mindestens eine der Spannungsquellen der Treiberschaltung unter Verwendung einer Bipolar-Transistor-Struktur und/oder einer MOSFET-Struktur, insbesondere als ASIC oder mittels diskreter Bauteile, realisiert. In dieser Ausführungsvariante kann die erfindungsgemäße Treiberschaltung besonders kostengünstig und/oder kompakt zur Verfügung gestellt werden. In einer solchen Ausführungsvariante kann die Spannung am Gate beispielsweise mittels einer Stromquelle dynamisch nachgebildet werden.

Des Weiteren wird ein niederinduktives Leistungsmodul mit einer erfindungsgemäßen Treiberschaltung bereitgestellt, welches einen Leistungstransistor mit einem Source-Kontakt und einem Gate-Kontakt aufweist, wobei der Source-Kontakt mit dem Anschluss der Treiberschaltung und der Gate-Kontakt mit dem Ausgang der Treiberschaltung verbunden ist. Bei derartigen Leistungsmodulen kommen die zuvor für die Treiberschaltung erwähnten Vorteile zum Tragen.

Bevorzugt ist der Leistungstransistor ein Siliziumcarbid-MOSFET. SiC MOSFETs, also Siliziumcarbid MOSFETs, bieten - verglichen beispielsweise mit anderen Schaltmitteln - signifikante Vorteile im Bereich der Schaltleistung, was unter anderem zu größeren Reichweiten für Elektrofahrzeuge beiträgt.

Bevorzugt meinen die Begriffe verbunden und/oder verbindbar eine elektrisch leitfähige Verbindung beziehungsweise eine elektrisch leitfähige Verbindbarkeit.

Bevorzugt ist die voreingestellte Mindestzeitspanne auf einen Wert von $2\mu s$ voreingestellt.

Bevorzugt ist die voreingestellte Mindestzeitspanne auf einen Wert von MZS voreingestellt, wobei $MZS \in [0,1\mu s; 5\mu s]$.

Vorteilhafte Weiterbildungen der Erfindung sind in den Unteransprüchen angegeben und in der Beschreibung beschrieben.

Zeichnungen

Ausführungsbeispiele der Erfindung werden anhand der Zeichnungen und der nachfolgenden Beschreibung näher erläutert. Es zeigen:

Figur 1     eine schematische Darstellung eines ersten Ausführungsbeispiels einer erfindungsgemäßen Treiberschaltung mit zwei Spannungsquellen in einem mit einem Leistungstransistor verbundenen Zustand;

Figur 2     eine erste Anwendung des ersten Ausführungsbeispiels der erfindungsgemäßen Treiberschaltung mit einem Leistungstransistor;

Figur 3      ein zweites Ausführungsbeispiel einer erfindungsgemäßen Treiberschaltung mit einer koppelbaren Induktivität;

Figur 4      ein drittes Ausführungsbeispiel einer erfindungsgemäßen Treiberschaltung, und

Figur 5      ein viertes Ausführungsbeispiel einer erfindungsgemäßen Treiberschaltung mit einem Mehrfach-Chip Leistungsmodul.

Ausführungsformen der Erfindung

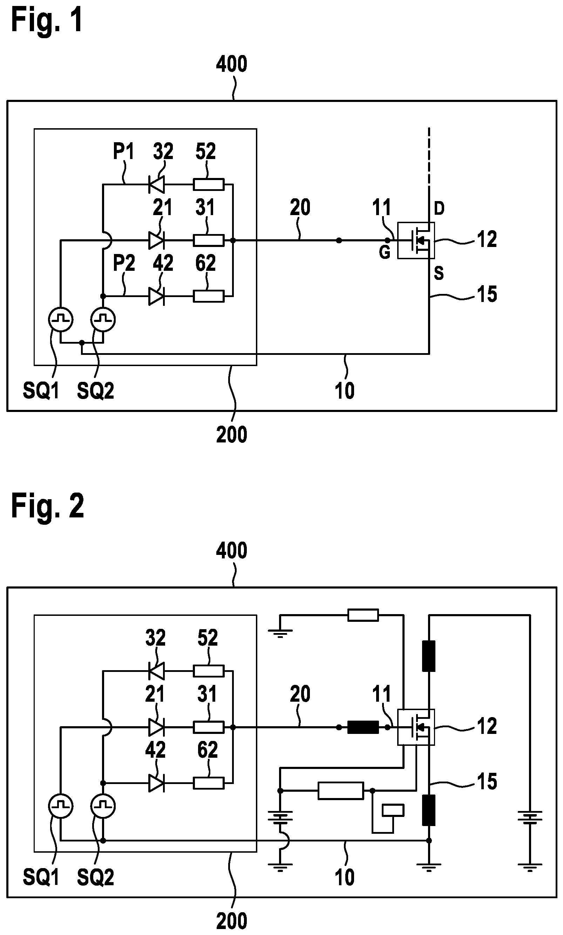

In der Figur 1 ist eine schematische Darstellung eines ersten Ausführungsbeispiels einer erfindungsgemäßen Treiberschaltung 200 mit zwei Spannungsquellen SQ1, SQ2 in einem mit einem Leistungstransistor verbundenen Zustand dargestellt. Diese erfindungsgemäße Treiberschaltung 200 ist für den Betrieb eines niederinduktiven Leistungsmoduls 400 ausgelegt, welches in diesem Ausführungsbeispiel rein beispielhaft als Siliziumcarbid-Leistungstransistor, genauer rein beispielhaft als Siliziumcarbid-MOSFET ausgeführt ist. Die erfindungsgemäße Treiberschaltung kann aber auch für andere Arten von Leistungsmodulen bzw. Leistungstransistoren verwandt werden. Die erfindungsgemäße Treiberschaltung 200 umfasst einen Anschluss 10 und einen Ausgang 20, wobei in Figur 1 der Anschluss 10 mit dem Source-Kontakt 15 eines Leistungstransistors 12 und der Ausgang 20 mit dem Gate-Kontakt 11 des Leistungstransistors 12 verbunden ist.

Die erfindungsgemäße Treiberschaltung 200 ist dazu ausgelegt, in einem ersten Betriebsmodus eine erste Gate-Source-Spannung $U_{GS1}$ für den Gate-Kontakt 11 des Leistungstransistors 12 zu erzeugen und an dem Ausgang 20 der Treiberschaltung 200 zur Verfügung zu stellen. Ferner ist die Treiberschaltung 200 dazu ausgelegt, in einem zweiten Betriebsmodus während wenigstens einer voreingestellten Mindestzeitspanne eine geringere zweite Gate-Source-Spannung $U_{GS2}$ für den Gate-Kontakt 11 des Leistungstransistors 12 zu erzeugen und an dem Ausgang 20 der Treiberschaltung 200 zur Verfügung zu stellen. In diesem Ausführungsbeispiel ist eine Kurzschluss-Erkennungsschaltung (in Figur 1 nicht dargestellt) mit dem Leistungstransistor 12 elektrisch leitfähig verbunden.

Die oben erwähnte voreingestellte Mindestzeitspanne entspricht in diesem ersten Ausführungsbeispiel derjenigen Zeitspanne, die von der mit dem Leistungstransistor 12 verbundenen Kurzschluss-Erkennungsschaltung benötigt wird, um einen Kurzschluss bei der Einschaltung des Leistungstransistors 12 zu erkennen und eine Abschaltung des Leistungstransistors 12 einzuleiten und vorzunehmen. Die voreingestellte Mindestzeitspanne kann aber auch der Ausblendzeit (Englisch "blanking time" genannt) der Kurzschluss-Erkennungsschaltung entsprechen und/oder flexible an ein von der Kurzschluss-Erkennungsschaltung erzeugtes Signal gekoppelt sein, sodass die Kurzschluss-Erkennungsschaltung die Treiberschaltung mittels eines Signals in den zweiten Betriebsmodus überführt oder diesen initiiert.

In diesem ersten Ausführungsbeispiel weist die Treiberschaltung 200 zwei verschiedene Spannungsquellen SQ1, SQ2 auf, mittels welchen die erste und die zweite Gate-Source-Spannung $U_{GS1}$, $U_{GS2}$ erzeugbar und am Ausgang 20 der Treiberschaltung 200 zur Verfügung stellbar sind. Es können allerdings auch erfindungsgemäße Treiberschaltungen 200 realisiert werden, welche nur eine Spannungsquelle oder mehr als zwei Spannungsquellen aufweisen. Die zwei verschiedenen Spannungsquellen SQ1 und SQ2 weisen jeweils einen mit dem Anschluss 10 der Treiberschaltung 200 verbundenen Eingang sowie jeweils einen Spannungsausgang auf. Der Spannungsausgang der ersten Spannungsquelle SQ1 ist in diesem ersten Ausführungsbeispiel rein beispielhaft über eine Reihenschaltung aus einer ersten Diode 21 und einem ersten Widerstand 31 mit dem Ausgang 20 der Treiberschaltung 200 verbunden. Der Spannungsausgang der zweiten Spannungsquelle SQ2 ist in diesem ersten Ausführungsbeispiel rein beispielhaft über eine Parallelschaltung zweier Pfade P1, P2 mit dem Ausgang 20 der Treiberschaltung 200 verbunden, wobei in jedem der Pfade eine Diode 32, 42 und ein Widerstand 52, 62 vorgesehen ist.

In diesem ersten Ausführungsbeispiel umfasst die erfindungsgemäße Treiberschaltung 200 ferner eine Ansteuerschaltung (nicht dargestellt in Figur 1), welche die Spannungsquellen SQ1 und SQ2 entsprechend eines vorbestimmten Algorithmus betreibt. Der Algorithmus betreibt die Treiberschaltung 200 also wechselnd im ersten beziehungsweise zweiten Betriebsmodus.

Figur 2 zeigt eine erste Anwendung des ersten Ausführungsbeispiels der erfindungsgemäßen Treiberschaltung 200 mit einem Leistungstransistor 12. In dieser in Figur 2 dargestellten Anwendung weist das Leistungsmodul, welches hier unter anderem die Treiberschaltung 200 und den Leistungstransistor umfasst, noch weitere elektronische Komponenten beziehungsweise Bauteile auf, die für den von der erfindungsgemäßen Treiberschaltung 200 bereitgestellten technischen Effekt aber nicht weiter von Bedeutung sind. Es ist wichtig zu verstehen, dass der erfindungsgemäße Zweck auf verschiedene Weise erreicht werden kann. So können die zwei verschiedenen Gate-Source-Spannungen $U_{GS1}$, $U_{GS2}$ zum Beispiel dadurch bereitgestellt werden, dass die beiden Spannungsquellen SQ1 und SQ2 alternierend eingeschaltet werden (also nicht gemeinsam betrieben werden beziehungsweise eingeschaltet sind). Die zwei verschiedenen Gate-Source-Spannung $U_{GS1}$, $U_{GS2}$ können zum Beispiel aber auch durch eine zeitversetze Einschaltung der beiden Spannungsquellen SQ1 und SQ2 bereitgestellt werden, sodass zunächst zum Beispiel die zweite Spannungsquelle SQ2 zur Bereitstellung der zweiten Gate-Source-Spannung $U_{GS2}$ eingeschaltet wird und nach Ablauf der voreingestellten Mindestzeitspanne die erste Spannungsquelle SQ1 zur Bereitstellung der ersten Gate-Source-Spannung $U_{GS1}$ hinzugeschaltet wird. Bei dieser Ausführung werden die Spannungen der beiden Spannungsquellen SQ1 und SQ2 also superpositioniert.

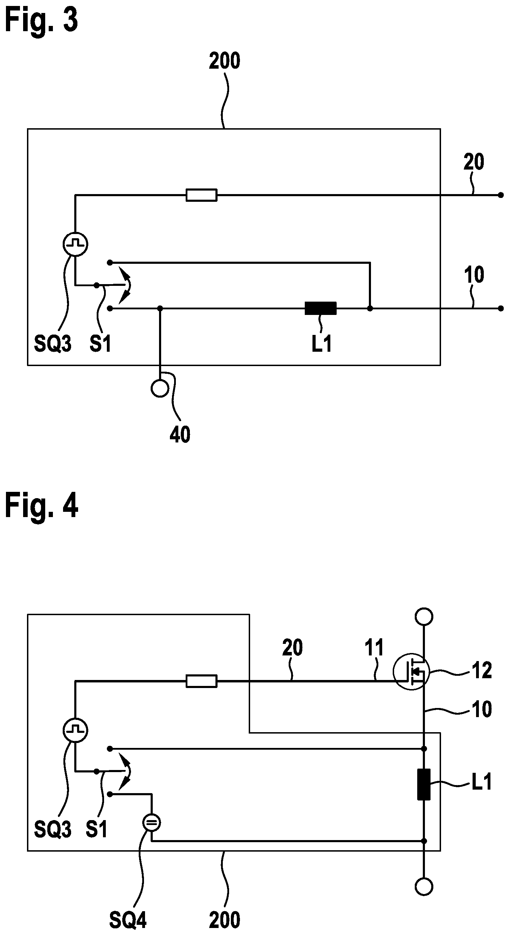

Figur 3 zeigt ein zweites Ausführungsbeispiel einer erfindungsgemäßen Treiberschaltung 200 mit einer koppelbaren Induktivität L1. In diesem Ausführungsbeispiel ist zwischen dem Ausgang 20 und dem Anschluss 10 der Treiberschaltung 200 lediglich eine Spannungsquelle SQ3 vorgesehen, mittels welcher der Ausgang 20 der Treiberschaltung 200 mit einer Spannung beaufschlagbar ist. Ferner ist eine Induktivität L1 mittels eines Schaltmittels S1 dem elektrischen Pfad zwischen der mindestens einen Spannungsquelle und dem Anschluss 10 reversibel hinzuschaltbar. Wie bereits oben erläutert fungiert die reversibel hinzuschaltbare Induktivität hier als optionales Source Feedback für einen mit der Treiberschaltung verbundenen Leistungstransistor, welches Kurzschluss-Stromspitzen innerhalb des Leistungsmoduls/Leistungstransistors bei gleichbleibender Schaltleistung reduziert. In diesem zweiten Ausführungsbeispiel führt die Induktivität L1 den vollen Laststrom. Sie kann in anderen Ausführungen aber auch einen Strom führen, der geringer ist als der volle Laststrom. Mittels des Abgriffs 40, welcher hier einen Leistungsabgriff darstellt, kann die Treiberschaltung 200 in einem mit einem Leistungsmodul verbundenen Zustand mit weiteren Komponenten, zum Beispiel einer Last verbunden werden.

Figur 4 zeigt ein drittes Ausführungsbeispiel einer erfindungsgemäßen Treiberschaltung 200, welches weitgehend mit dem in Figur 3 dargestellten identisch ist, jedoch ferner eine weitere Spannungsquelle SQ4 umfasst, welche mit der Induktivität L1 in Reihe geschaltet ist und mittels des Schaltmittels S1 gemeinsam mit der Induktivität L1 dem elektrischen Pfad zwischen der mindestens einen Spannungsquelle SQ3 und dem Anschluss 10 reversibel hinzuschaltbar ist. Insbesondere in dieser dritten Ausführung bietet die erfindungsgemäße Treiberschaltung 200 einen effizienten Schutz gegen beide Kurzschlusstypen 1 und 2. Auch in diesem dritten Ausführungsbeispiel führt die Induktivität L1 rein beispielhaft den vollen Laststrom. Sie kann in anderen Ausführungen aber auch einen Strom führen, der geringer ist als der volle Laststrom.

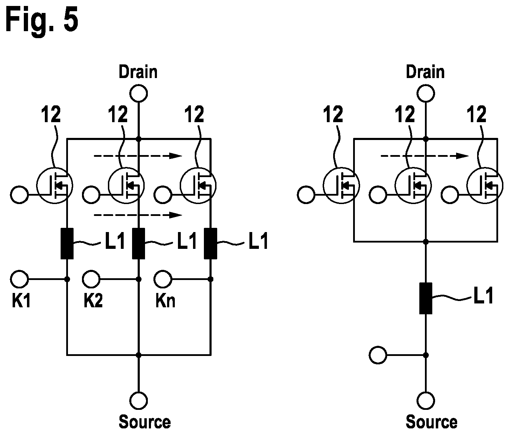

Figur 5 zeigt einen Teil eines vierten Ausführungsbeispiels einer erfindungsgemäßen Treiberschaltung 200 mit einem Mehrfach-Chip Leistungsmodul. Dabei sind zwei verschiedene Schaltungsvarianten einander gegenübergestellt. Links in Figur 5 ist eine erste Schaltungsvariante gezeigt, bei welcher jeder einzelne Chip beziehungsweise jeder auf einem solchen Chip realisierte Leistungstransistor 12 ein eigenes Source-Feedback aufweist. Hier umfasst also jeder einzelne auf einem Chip realisierte Leistungstransistor 12 eine eigene, reversible dem Source-Pfad des jeweiligen Leistungstransistors 12 hinzuschaltbare Induktivität L1. In der links in Figur 5 gezeigten Schaltungsvariante beziehungsweise Schaltungskonfiguration müssen die Gate-Kontakte der Leistungstransistoren 12 im Leistungsmodul und/oder in der Treiberschaltung 200 miteinander elektrisch leitfähig verbunden sein. Auch müssen die Anschlüsse K1 bis Kn der Induktivitäten L1 in der Treiberschaltung 200 oder im Leistungsmodul elektrisch leitfähig miteinander verbunden sein, oder es muss - alternativ dazu - je Induktivität L1 ein Schaltmittel zum herein- oder herauskoppeln der jeweiligen Induktivität L1 in den jeweiligen Source-Pfad des jeweiligen Leistungstransistors 12 vorgesehen sein. Ferner sollten bei dieser ersten Schaltungsvariante sämtliche Induktivitäten L1 symmetrisch ausgeführt sein, um Oszillationen der Gesamtschaltung zu reduzieren.

Rechts in Figur 5 ist eine zweite Schaltungskonfiguration gezeigt, welche ein gemeinsames Source-Feedback für alle Chips beziehungsweise für alle auf jeweils einem Chip realisierten Leistungstransistoren 12 umfasst. Hier ist also lediglich eine reversible den Source-Pfaden sämtlicher Leistungstransistoren 12 gemeinsam hinzuschaltbare Induktivität L1 vorgesehen. Auch in dieser rechts in Figur 5 gezeigten Schaltungsvariante beziehungsweise Schaltungskonfiguration müssen die Gate-Kontakte der Leistungstransistoren 12 im Leistungsmodul und/oder in der Treiberschaltung 200 miteinander elektrisch leitfähig verbunden sein. Allerdings reicht bei dieser Schaltungsvariante lediglich ein Schaltmittel aus, um die Hinzuschaltbarkeit beziehungsweise die Herauskoppelbarkeit der einen gemeinsamen Induktivität L1 zu gewährleisten.

**Patentansprüche**

1. Treiberschaltung (200) für ein niederinduktives Leistungsmodul (400), umfassend

   einen Anschluss (10) und
   einen Ausgang (20),
   wobei der Anschluss (10) mit dem Source-Kontakt (15) eines Leistungstransistors (12) und der Ausgang (20) mit dem Gate-Kontakt (11) des Leistungstransistors (12) verbindbar ist und
   wobei die Treiberschaltung (200) dazu ausgelegt ist, in einem ersten Betriebsmodus eine erste Gate-Source-Spannung ($U_{GS1}$) für den Gate-Kontakt (11) des Leistungstransistors (12) zu erzeugen und an dem Ausgang (20) der Treiberschaltung (200) zur Verfügung zu stellen;
   wobei die Treiberschaltung (200) ferner dazu ausgelegt ist, in einem zweiten Betriebsmodus während wenigstens einer voreingestellten Mindestzeitspanne eine geringere zweite Gate-Source-Spannung ($U_{GS2}$) für den Gate-Kontakt (11) des Leistungstransistors (12) zu erzeugen und an dem Ausgang (20) der Treiberschaltung (200) zur Verfügung zu stellen,

**dadurch gekennzeichnet, dass**
die voreingestellte Mindestzeitspanne derjenigen Zeitspanne entspricht, die von einer mit dem Leistungstransistor (12) verbundenen Kurzschluss-Erkennungsschaltung benötigt wird, um einen Kurzschluss bei der Einschaltung des Leistungstransistors (12) zu erkennen und eine Abschaltung des Leistungstransistors (12) einzuleiten und/oder vorzunehmen.

2. Treiberschaltung (200) nach Anspruch 1, wobei die Treiberschaltung (200) zwei verschiedene Spannungsquellen (SQ1, SQ2) umfasst, mittels welchen die erste und die zweite Gate-Source-Spannung ($U_{GS1}$; $U_{GS1}$) erzeugbar und am Ausgang (20) der Treiberschaltung (200) zur Verfügung stellbar sind.

3. Treiberschaltung (200) nach Anspruch 2, wobei die zwei verschiedenen Spannungsquellen (SQ1; SQ2) jeweils einen mit dem Anschluss (10) der Treiberschaltung (200) verbundenen Eingang sowie jeweils einen Spannungsausgang haben, wobei der Spannungsausgang der ersten Spannungsquelle (SQ1) über eine Reihenschaltung aus einer ersten Diode (21) und einem ersten Widerstand (31) mit dem Ausgang (20) der Treiberschaltung (200) verbunden ist, während der Spannungsausgang der zweiten Spannungsquelle (SQ2) über eine Parallelschaltung zweier Pfade (P1, P2) mit dem Ausgang (20) der Treiberschaltung (200) verbunden ist, wobei in jedem der Pfade eine Diode (32, 42) und/oder ein Widerstand (52, 62) vorgesehen ist.

4. Treiberschaltung (200) nach Anspruch 3, ferner umfassend eine Ansteuerschaltung, welche die Spannungsquellen (SQ1; SQ2) entsprechend eines vorbestimmten Algorithmus betreibt.

5. Treiberschaltung (200) nach Anspruch 1 oder 2, wobei zwischen dem Ausgang (20) und dem Anschluss (10) der Treiberschaltung (200) mindestens eine Spannungsquelle (SQ3) vorgesehen ist, mittels welcher der mit dem Gate-Kontakt (11) des Leistungstransistors (12) verbindbare Ausgang (20) der Treiberschaltung (200) mit einer Spannung beaufschlagbar ist, wobei mindestens eine zwischen der Induktivität (L1) mittels eines Schaltmittels (S1) dem elektrischen Pfad zwischen der mindestens einen Spannungsquelle und dem mit dem Source-Kontakt (15) des Leistungstransistors (12) verbindbaren Anschluss (10) reversibel hinzuschaltbar ist.

6. Treiberschaltung (200) nach Anspruch 5, ferner umfassend eine weitere Spannungsquelle (SQ4), welche mit der Induktivität (L1) in Reihe geschaltet ist und mittels des Schaltmittels (S1) gemeinsam mit der Induktivität (L1) dem elektrischen Pfad, welcher an dem mit dem Gate-Kontakt (11) des Leistungstransistors (12) verbindbaren Ausgang (20) startet, zwischen der mindestens einen Spannungsquelle (SQ3) und dem mit dem Source-Kontakt (15) des Leistungstransistors (12) verbindbaren Anschluss (10) reversibel hinzuschaltbar ist.

7. Treiberschaltung (200) nach Anspruch 6, wobei mindestens eine der Spannungsquellen (SQ1, SQ2, SQ3, SQ4) der Treiberschaltung (200) einen linearen Regler, einen RC Spannungsteiler, mindestens einen Bipolar-Transistor und/oder eine Bootstrap-Schaltung aufweist und/oder wobei mindestens eine der Spannungsquellen (SQ1, SQ2, SQ3, SQ4) der Treiberschaltung (200) unter Verwendung einer Bipolar-Transistor-Struktur und/oder einer MOSFET-Struktur, insbesondere als ASIC oder mittels diskreter Bauteile, realisiert ist.

8. Niederinduktives Leistungsmodul (400) mit einer Treiberschaltung (200) nach einem der Ansprüche 1 bis 7, umfassend einen Leistungstransistor (12) mit einem Source-Kontakt (15) und einem Gate-Kontakt (11), wobei der Source-Kontakt (15) mit dem Anschluss (10) der Treiberschaltung (200) und der Gate-Kontakt (11) mit dem Ausgang (20) der Treiberschaltung (200) verbunden ist.

9. Niederinduktives Leistungsmodul (400) nach Anspruch 8, wobei der Leistungstransistor ein Siliziumcarbid-MOSFET ist.

**Claims**

1. Driver circuit (200) for a low-inductance power module (400), comprising a connection (10) and

   an output (20),
   wherein the connection (10) is able to be connected to the source contact (15) of a power transistor (12) and the output (20) is able to be connected to the gate contact (11) of the power transistor (12), and
   wherein the driver circuit (200) is designed, in a first operating mode, to generate a first gate-source voltage ($U_{GS1}$) for the gate contact (11) of the power transistor (12) and to provide it at the output (20) of the driver circuit (200);
   wherein the driver circuit (200) is furthermore designed, in a second operating mode, during at least one preset minimum time period, to generate a lower, second gate-source voltage ($U_{GS2}$) for the gate contact (11) of the power transistor (12) and to provide it at the output (20) of the driver circuit (200),
   **characterized in that**
   the preset minimum time period corresponds to that time period that is required by a short-circuit detection circuit connected to the power transistor (12) to detect a short circuit when the power transistor (12) is switched on and to initiate and/or perform a shutdown of the power transistor (12).

2. Driver circuit (200) according to Claim 1, wherein the driver circuit (200) comprises two different voltage sources (SQ1, SQ2), by means of which the first and the second gate-source voltage ($U_{GS1}$; $U_{GS1}$) are able to be generated and made available at the output (20) of the driver circuit (200).

3. Driver circuit (200) according to Claim 2, wherein the two different voltage sources (SQ1; SQ2) each have an input connected to the connection (10) of the driver circuit (200) and each have a voltage output, wherein the voltage output of the first voltage source (SQ1) is connected to the output (20) of the driver circuit (200) via a series circuit comprising a first diode (21) and a first resistor (31), while the voltage output of the second voltage source (SQ2) is connected to the output (20) of the driver circuit (200) via a parallel circuit comprising two paths (P1, P2), wherein a diode (32, 42) and/or a resistor (52, 62) is provided in each of the paths.

4. Driver circuit (200) according to Claim 3, furthermore comprising an actuation circuit that operates the voltage sources (SQ1; SQ2) in accordance with a predetermined algorithm.

5. Driver circuit (200) according to Claim 1 or 2, wherein at least one voltage source (SQ3) is provided between the output (20) and the connection (10) of the driver circuit (200), by means of which voltage source a voltage is able to be applied to the output (20), which is able to be connected to the gate contact (11) of the power transistor (12), of the driver circuit (200), wherein, by means of a switching means (S1), at least one between the inductor (L1) is able to be reversibly connected into the electrical path between the at least one voltage source and the connection (10) that is able to be connected to the source contact (15) of the power transistor (12).

6. Driver circuit (200) according to Claim 5, furthermore comprising a further voltage source (SQ4) that is connected in series with the inductor (L1) and, by means of the switching means (S1), together with the inductor (L1), is able to be reversibly connected into the electrical path, which starts at the output (20) that is able to be connected to the gate contact (11) of the power transistor (12), between the at least one voltage source (SQ3) and the connection (10) that is able to be connected to the source contact (15) of the power transistor (12).

7. Driver circuit (200) according to Claim 6, wherein at least one of the voltage sources (SQ1, SQ2, SQ3, SQ4) of the driver circuit (200) has a linear controller, an RC voltage divider, at least one bipolar transistor and/or a bootstrap circuit, and/or wherein at least one of the voltage sources (SQ1, SQ2, SQ3, SQ4) of the driver circuit (200) is implemented using a bipolar transistor structure and/or a MOSFET structure, in particular in the form of an ASIC or by means of discrete components.

8. Low-inductance power module (400) having a driver circuit (200) according to one of Claims 1 to 7, comprising a power transistor (12) having a source contact (15) and a gate contact (11), wherein the source contact (15) is connected to the connection (10) of the driver circuit (200) and the gate contact (11) is connected to the output (20) of the driver circuit (200).

9. Low-inductance power module (400) according to Claim 8, wherein the power transistor is a silicon carbide MOSFET.

**Revendications**

1. Circuit d'attaque (200) pour un module de puissance à faible inductance (400), comprenant

une connexion (10) et
une sortie (20),
la connexion (10) pouvant être reliée au contact de source (15) d'un transistor de puissance (12) et la sortie (20) pouvant être reliée au contact de grille (11) du transistor de puissance (12) et
le circuit d'attaque (200) étant conçu pour générer, dans un premier mode de fonctionnement, une première tension source-grille ($U_{GS1}$) pour le contact de grille (11) du transistor de puissance (12) et pour fournir celle-ci à la sortie (20) du circuit d'attaque (200) ;
le circuit d'attaque (200) étant en outre conçu pour générer, dans un second mode de fonctionnement pendant au moins une période minimale prédéfinie, une seconde tension source-grille inférieure ($U_{GS2}$) pour le contact de grille (11) du transistor de puissance (12) et pour fournir celle-ci à la sortie (20) du circuit d'attaque (200),
**caractérisé en ce que**
la période minimale prédéfinie correspond à la période de temps requise par un circuit de détection de court-circuit relié au transistor de puissance (12) pour détecter un court-circuit lors de la mise sous tension du transistor de puissance (12) et pour déclencher et/ou effectuer une mise hors tension du transistor de puissance (12).

2. Circuit d'attaque (200) selon la revendication 1, le circuit d'attaque (200) comprenant deux sources de tension différentes (SQ1, SQ2), au moyen desquelles les première et seconde tensions source-grille ($U_{GS1}$ ; $U_{GS1}$) peuvent être générées et fournies à la sortie (20) du circuit d'attaque (200).

3. Circuit d'attaque (200) selon la revendication 2, dans lequel les deux sources de tension différentes (SQ1 ; SQ2) ont chacune une entrée connectée à la connexion (10) du circuit d'attaque (200) et ont chacune une sortie de tension, la sortie de tension de la première source de tension (SQ1) étant reliée à la sortie (20) du circuit d'attaque (200) par l'intermédiaire d'un circuit série composé d'une première diode (21) et d'une première résistance (31), tandis que la sortie de tension de la seconde source de tension (SQ2) est reliée à la sortie (20) du circuit d'attaque (200) par l'intermédiaire d'un circuit parallèle de deux trajets (P1, P2), une diode (32, 42) et/ou une résistance (52, 62) étant prévue sur chacun des trajets.

4. Circuit d'attaque (200) selon la revendication 3, comprenant en outre un circuit de commande, lequel commande les sources de tension (SQ1 ; SQ2) selon un algorithme prédéterminé.

5. Circuit d'attaque (200) selon la revendication 1 ou 2, dans lequel il est prévu entre la sortie (20) et la connexion (10) du circuit d'attaque (200) au moins une source de tension (SQ3) au moyen de laquelle la sortie (20) du circuit d'attaque (200) pouvant être reliée au contact de grille (11) du transistor de puissance (12) peut être soumise à une tension, au moins une entre l'inductance (L1) pouvant être raccordée de manière réversible, au moyen d'un moyen de commutation (S1), au trajet électrique entre ladite au moins une source de tension et la connexion (10) pouvant être reliée au contact source (15) du transistor de puissance (12).

6. Circuit d'attaque (200) selon la revendication 5, comprenant en outre une autre source de tension (SQ4), qui est connectée en série avec l'inductance (L1) et peut être raccordée de manière réversible, au moyen du moyen de commutation (S1), conjointement avec l'inductance (L1), au trajet électrique qui commence à la sortie (20) pouvant être reliée au contact de grille (11) du transistor de puissance (12), entre ladite au moins une source de tension (SQ3) et la connexion (10) pouvant être reliée au contact source (15) du transistor de puissance (12).

7. Circuit d'attaque (200) selon la revendication 6, dans lequel au moins l'une des sources de tension (SQ1, SQ2, SQ3, SQ4) du circuit d'attaque (200) comprend un régulateur linéaire, un diviseur de tension RC, au moins un transistor bipolaire et/ou un circuit d'amorçage, et/ou dans lequel au moins l'une des sources de tension (SQ1, SQ2, SQ3, SQ4) du circuit d'attaque (200) est réalisée par utilisation d'une structure de transistor bipolaire et/ou d'une structure MOSFET, en particulier sous forme d'ASIC ou au moyen de composants discrets.

8. Module de puissance à faible inductance (400) ayant un circuit d'attaque (200) selon l'une quelconque des revendications 1 à 7, comprenant un transistor de puissance (12) comportant un contact de source (15) et un contact de grille (11), le contact de source (15) étant relié à la connexion (10) du circuit d'attaque (200) et le contact de grille (11) étant relié à la sortie (20) du circuit d'attaque (200).

9. Module de puissance à faible inductance (400) selon la revendication 8, dans lequel le transistor de puissance est un MOSFET au carbure de silicium.

# Fig. 1

# Fig. 2

# Fig. 3

# Fig. 4

# Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9490798 B1
- US 10193544 B2
- EP 3035532 A1
- EP 2999118 A1